**Europäisches Patentamt**

(19) **European Patent Office**

**Office européen des brevets**

(11) Veröffentlichungsnummer: **0 011 119**

**A1**

(12) # EUROPÄISCHE PATENTANMELDUNG

(21) Anmeldenummer: **79103761.7**

(51) Int. Cl.³: **G 05 B 19/10**

(22) Anmeldetag: **03.10.79**

(30) Priorität: **12.10.78 DE 2844388**
**18.04.79 DE 2915528**

(43) Veröffentlichungstag der Anmeldung:
**28.05.80 Patentblatt 80 11**

(84) Benannte Vertragsstaaten:
**AT BE CH DE FR GB IT NL SE**

(71) Anmelder: **WLW-Elektrotechnik GmbH & Co. KG**
**Moltkestrasse 1**
**D-4150 Krefeld 1(DE)**

(72) Erfinder: **Lezius, Albrecht**
**Corneliusplatz 65**
**D-4154 Tönisvorst 1(DE)**

(72) Erfinder: **Wunsch, Reinhold**
**Friedrich-Ebert-Strasse 62**
**D-4150 Krefeld 1(DE)**

(74) Vertreter: **Stratmann, Ernst, Dr.-Ing. et al,**
**Schadowplatz 9**
**D-4000 Düsseldorf 1(DE)**

(54) **Anzeige- und Bedienungselement.**

(57) Ein Anzeige- und Bedienungselement (12) wird beschrieben, das mehrere ggf. sich gegenseitig auslösende Leuchtdrucktasten auf einer in ein Gehäuse einschiebbaren Karte aufweist, wobei die Funktion dieser Leuchtdrucktasten sowie die ggf. gewüschte gegenseitige Auslösung elektrisch mit Hilfe von Schaltkreisen fastgelegt wird, deren Anordnung hzw. Einstellung ohne Verdrahtungsänderung mittels auf der Steckkarte angeordneter Codierschalter, Kreuzschienenverteiler, Steckbrücken o. dgl. oder auch durch die Programmierung eines Mikroprozessors einstellbar ist, der vorzugsweise in einer besonderen Steckkarte untergebracht ist. Bei größeren zu steuernden Anlagen lassen sich mehrere derartige Elemente in einem Gehause vereinigen und ggf. auch mehrere derartige Gehäuse miteinander über Datenleitungen verbinden, wobei es dann zweckmäßig ist, den Mikroprozessor in einem Zentralgehäuse (60) unterzubringen und dazu zu verwenden, alle Anzeige- und Bedienungselemente bezüglich ihrer Funktion und gegenseitigen Auslösung zentral zu steuern. Das Anzeige- ung Bedienungselement ersetzt wegen seiner Vielseitigkeit die bisher bei Steuerungsanlagen, die beispielsweise für Klimaanlagen eingesetzt werden, notwendigen unterschiedlichen Anzeige- und Bedienungselemente und ergibt dadurch eine erhebliche Kosteneinsparung sowohl hinsichtlich der Steuerungseinrichtungen wie auch hinsichtlich deren Aufbau und der Wartung.

Fig 4

ZU WEITEREN
STEUEREINHEITEN 10

PROGRAMMIERKOFFER

PROGRAMMDRUCKER

ZENTRALGERÄT

DR.-ING. ERNST STRATMANN
PATENTANWALT
D-4000 DÜSSELDORF 1 · SCHADOWPLATZ 9

· 7926 EU

· WLW-Elektrotechnik GmbH & Co. KG
4150 Krefeld 1

· Anzeige- und Bedienungselement

· Die Erfindung betrifft ein Anzeige- und Bedienungselement, das mehrere, ggf. sich gegenseitig auslösende Leuchtdrucktasten auf einer in ein Gehäuse einschiebbaren Karte aufweist.

Derartige Anzeige- und Bedienungselemente sind bereits bekannt. In einem Prospekt der Firm Klöckner-Möller aus dem Jahre 1977 (Bezeichnung des Prospektes: Electronic spezial G 27 - 2043), wird eine Steuerungs-, Melde- und Überwachungseinrichtung für Antriebe beschrieben, die mit der Bezeichnung "SUCOS 530" versehen ist. Das dort beschriebene System besteht aus Steckbaugruppen in "Europaformat-Einschubtechnik" mit den Abmessungen 100 x 160 x 1,5 mm, wobei als Steckverbinder Federleisten dienen. Die Steckbaugruppen werden in 19"-Baugruppenträger nach DIN 41494 eingebaut. Die Frontplatten der Steckbaugruppen bilden nach Einschub in das "Europagehäuse" eine geschlossene und übersichtliche Bedienungsfläche mit allen für den Betriebsablauf erforderlichen Bedienungselementen, Betriebs- und Störmeldeanzeigen.

Das bekannte System weist bereits viele Vorteile gegenüber früheren Konstruktionen auf, so wird durch kompakte Bauweise Platz eingespart, durch das Baukastensystem ist die Anlage

0011119

leicht zu erweitern, außerdem wird durch die Anwendung von
Funktionseinheiten mit internen Verknüpfungen und Verriegelungen
die Wartung erleichtert. Durch die fabrikfertigen Funktionseinheiten mit integrierten Befehlsgebern und Leuchtmeldern ist
außerdem der Montage- und Wartungsaufwand verhältnismäßig klein.

Das bekannte System weist dabei auch noch erhebliche Nachteile
auf. So beschreibt die Druckschrift insgesamt 16 verschiedene
Steckbaugruppen, die alle nicht nur intern unterschiedlich aufgebaut sind, sondern auch auf der Frontseite unterschiedliche
Gestalt haben. Durch diese Unterschiedlichkeit der einzelnen
Steckbaugruppen sind die Herstellungskosten des bekannten Systems
noch verhältnismäßig sehr hoch und eine Erweiterung einer Anlage
erfordert verhältnismäßig aufwendige Planung und Zeitaufwand, da
möglicherweise die benötigte Steckbaugruppe beim Hersteller erst
bestellt werden muß, wobei der Hersteller möglicherweise eine
entsprechende Type erst (ggf. in Einzelfertigung) herstellen muß.
Ähnliches gilt bei Ersatz von bereits vorhandenen Steckbaugruppen
Werden in der zu steuernden oder zu überwachenden Anlage Geräte
ausgewechselt, ist bei der bekannten Steuerungsanlage meist auch
ein Ersatz der entsprechenden Steckbaugruppe notwendig, was mit
den vorstehend geschilderten Umständen und Kosten verbunden ist.

Aufgabe der Erfindung ist es, ein Anzeige- und Bedienungselement
der eingangs genannten Art zu schaffen, das wesentlich universeller anwendbar ist und an praktisch jede Aufgabenstellung
durch auch vom Anwender vornehmbare Codierung oder Programmierung
angepaßt werden kann.

Gelöst wird diese Aufgabe durch die Merkmale des Hauptanspruchs,
also dadurch, daß die Funktion und ggf. gewünschte gegenseitige
Auslösung elektrisch mit Hilfe von Schaltkreisen erfolgt, deren
Anordnung bzw. Einstellung ohne Verdrahtungsänderung mittels
auf der Steckkarte angeordneter Codierschalter, Kreuzschienenverteiler, Steckbrücken o. dgl., oder durch die Software (Programmierung) eines Mikroprozessors festgelegt wird.

Durch diese Konstruktion gelingt es, das Anzeige- und Bedienungselement an praktisch jede vorkommende Aufgabe in einfachster Weise anzupassen, indem entweder die Codierschalter, Kreuzschienenverteiler, Steckbrücken o. dgl. umgeschaltet bzw. umgesteckt werden, oder indem das gespeicherte Programm des ggf. vorhandenen Mikroprozessors in bekannter Weise an die Gegebenheiten angepaßt wird. Je nach Anlagengröße können zahlreiche derartige erfindungsgemäße Anzeige- und Bedienungselemente gleicher Konstruktion notwendig werden, wobei je nach Aufgabe die auf dem Element vorhandenen Leuchtdrucktasten entweder als Bedienungsschalter (Drucktaste) arbeiten, oder auch als Anzeige (Signallampe), oder aber auch gleichzeitig als Anzeige- und Bedienungstaste. Da nur ein Typ des erfindungsgemäßen Anzeige- und Bedienungselementes - ggf. ergänzt durch Steckkarten, die die Leistungsversorgung vornehmen oder die als Schnittstellen zwischen Steuersystem und zu steuernde Anlage dienen, sowie ggf. eine Steckkarte mit einem Mikroprozessor - erforderlich ist, ergeben sich ganz bedeutende Kosteneinsparungen nicht nur bei der Herstellung der Grundeinheiten, sondern auch beim Aufbau des Gesamtsystems am Einsatzort.

Werden mehr als ein Anzeige- und Bedienungselement benötigt, weil z. B. ein sehr umfangreiches System gesteuert werden muß, können mehrere Anzeige- und Bedienungselemente nebeneinander angeordnet und beispielsweise mit Hilfe von Steckkontaktleisten elektrisch miteinander verbunden werden. Diese Steckkontaktleisten sind ihrerseits über vielpolige Bandkabel, Druckplatten o. dgl. miteinander verbunden, wobei es besonders günstig ist, wenn alle Karten nicht nur identisch aufgebaut sind, sondern auch bezüglich ihrer einzelnen Steckkontakte parallelgeschaltet werden können, wodurch die Verdrahtung sich noch weiter vereinfacht.

Das Anzeige- und Bedienungselement läßt sich noch universeller anwendbar machen, wenn ein oder mehrere jeweils das Anzeige- und Bedienungselement tragende Karten zusammen mit ggf. mit Relais oder Optokopplern bestückten und als Schnittstelle zwischen Steuersystem und zu steuernden Anlage dienenden Ein/Ausgabekarten innerhalb eines Gehäuses angeordnet sind und über Datenbusleitungen mit weiteren, mit Karten bestückten Gehäusen und/oder mit einem Zentralgerät verbunden ist, über das mittels einer Programmiereinrichtung vorhandene Mikroprozessoren programmierbar sind. Dabei kann gemäß einer Weiterbildung der Erfindung die Programmiereinrichtung einen Programmdrucker zum Ausdruck des gespeicherten Programms aufweisen, insbesondere in Form von Stromlaufplansymbolen. Dadurch wird es in einfacher Weise möglich, das gespeicherte Programm zu überprüfen.

Für den Fall, daß eine Karte einen Mikroprozessor aufweist, ist es günstig, wenn diese Karte dann mit mehreren mit Leuchtdrucktasten versehenen und einander identischen Karten elektrisch über die Steckkontaktleisten verbunden ist, wiederum vorzugsweise bezüglich ihrer einzelnen Steckkontakte parallel zueinander.

Gemäß einer noch anderen Ausführungsform der Erfindung besitzt die Steckkarte für die Bildung der Funktions- und Auslöseschaltkreise integrierte Schaltkreise (IC), wodurch beispielsweise die Anzeigelampe im Blinkbetrieb betrieben werden könnte, ohne daß dazu von außen her der Blinkrhytmus eingesteuert werden muß. Außerdem kann die Steckkarte für den Betrieb der Leuchtelemente der Leuchtdrucktasten (z. B. Glühbirnen oder Leuchtdioden) einen Halbleiterlampentreiberkreis aufweisen.

Sind mehrere Karten vorgesehen, die vom Mikroprozessor angesteuert werden, besitzt jede Karte günstigerweise eine z. B. aus binärem Codierschalter, Steckbrücken o. dgl. bestehende Adressencode-Einrichtungen, die die Tastenfunktion der Tasten der Karte und/oder die Adresse der Karte festlegt, also die Stelle des Kartenabtastzyklus des Mikroprozessors, an der die jeweilige Karte angesteuert bzw. deren Daten abgetastet werden.

Die Kartenadressierung braucht allerdings nicht unbedingt durch entsprechende Codiereinrichtungen auf der Karte selbst durchgeführt zu werden, dies kann auch einfach durch die Stellung dieser Karte innerhalb einer Gruppe von Karten geschehen, falls die einzelnen Karten bezüglich dieser Adressierung nicht mit den anderen Karten parallelgeschaltet sind, sondern insoweit jeweils getrennte Zuleitungen aufweisen. Entsprechend wäre das die Karten aufnehmende Gehäuse anders zu verdrahten.

Wird ein Zentralgerät benutzt, kann dieses zweckmäßigerweise mit einem 8-Bit-Mikroprozessor und einem ergänzenden 1-Bit-Mikroprozessor versehen werden, außerdem mit Speicherraum für alle angeschlossenen Einzeltasten, für einen internen festen Arbeitsprogrammteil und für einen frei programmierbaren Arbeitsprogrammteil, wobei die Speicherung des internen festen Arbeitsprogrammteils vorzugsweise in PROM-Speicherkarten mit unverlierbarem Inhalt erfolgt, während die Speicherung des frei programmierbaren Arbeitsprogrammteils entweder ebenfalls in PROM-Speicherkarten oder aber, zum Zwecke der leichteren Änderbarkeit dieses Arbeitsprogrammteils, in batteriegepufferten RAM-Speicherkarten erfolgen kann.

Um die Anlage vor Inbetriebnahme, aber auch zur regelmäßigen Über=wachung austesten zu können und/oder um das Anwenderprogramm schnell ergänzen oder ändern zu können, ist es günstig, für diesen Zweck besondere RAM-Speicherkarten vorzusehen. Bestimmte ausgetestete Programme können zur größeren Sicherheit in PROM-Speicherkarten untergebracht werden.

Die Busleitungen, also die Datenleitungen zwischen dem Zentralgerät und den einzelnen mit Karten bestückten Gehäusen können Ringleitungen sein, die zweckmäßigerweise als Koaxialkabel ausgebildet sind und eine Datenwortstruktur übertragen, die aus zumindest 12 Bitworten plus Vorzeichenbit besteht. Über derartige Busleitungen kann auch die Programmiereinrichtung angeschlossen sein, die beispielsweise einen Programmdrucker zum Ausdruck des gespeicherten Programms aufweist, insbesondere in Form von Stromlaufplansymbolen, was die Überprüfung der Anlage besonders erleichtert.

0011119

Die Konstruktion der einzelnen Karten, insbesondere der Aufwand
an Bauelementen läßt sich reduzieren, wenn die Taste über ein
RC-Glied entprellt ist, so daß besondere Schutzmaßnahmen digitaler
Art gegen Prellerscheinungen entbehrlich werden, und wenn alle
Steuerungs- und Speicherfunktionen, ggf. einschließlich der
gegenseitigen Auslösung der Leuchtdrucktasten von dem zentralen
Mikroprozessor aus erfolgt.

Die Karten werden zweckmäßigerweise in einer solchen Größe ausgeführt, daß sie entweder Europaformat aufweisen, oder Doppel-
Europaformat, so daß sie in gängige Europagehäuse bzw. Doppel-
Europagehäuse eingepaßt werden können. Dabei würde für ein Europaformat eine Karte mit fünf Tasten besonders günstig sein, während
für Doppel-Europaformat auch eine größere Anzahl von Tasten,
beispielsweise acht Tasten zweckmäßig ist, wobei noch zusätzlicher Raum für weitere Anzeigevorrichtungen vorhanden ist,
falls diese für zweckmäßig erachtet werden.

Es sei noch bemerkt, daß durch die Möglichkeit der matrixartigen
Anordnung mehrerer Karten mit jeweils mehreren Leuchtdrucktasten
sich eine Sichtfläche ergibt, die auch von größerer Entfernung
aus noch deutlich erkennbare Informationen liefern kann.

Das erfindungsgemäße Anzeige- und Bedienungselement ist besonders geeignet, um bei Klima-, Heizungs- oder Lüftungsanlagen
als Steuersystem zu dienen, wobei insbesondere auch die Anordnung von Ringleitungen sich anbietet, jedoch erstreckt sich
das Anwendungsgebiet auch auf Förderanlagen, Aufbereitungsanlagen sowie andere Anlagen, bei denen die Steuerung von insbesondere motorischen Antrieben notwendig ist.

Ein besonders großer Vorteil des erfindungsgemäßen Anzeige-
und Bedienungselementes ist der, daß sich die Leuchtdrucktasten
durch einfaches Einlegen von bestimmten Darstellungen und Bezeichnungen in einfachster Weise beschriften lassen.

0011119

Die Erfindung wird nachfolgend anhand von Ausführungsbeispielen
näher erläutert, die in den Zeichnungen dargestellt sind.

Es zeigt:

Fig. 1    eine aus mehreren Anzeige- und Bedienungselementen
          (Steckkarten) bestehende Steuereinheit;

Fig. 2    in perspektivischer Ansicht eine der Steckkarten
          der Steuereinheit gemäß Fig. 1 mit fünf Leuchtdrucktasten sowie Mikroschaltergruppen (Codierschalter)
          zur Funktionsfestlegung der Leuchttasten;

Fig. 3a   eine Draufsicht auf eine ähnliche Ausführungsform,

Fig. 3b   eine Seitenansicht der in Fig. 3a dargestellten Karte;

Fig. 4    schematisch eine aus mehreren Anzeige- und Bedienungselementen bestehende Steuereinheit im Zusammenhang
          mit einem Zentralgerät, einem Programmierkoffer und
          einem Programmdrucker;

Fig. 5    Beschriftungsbeispiele für zwei Anzeige- und Bedienungselemente;

Fig. 6    als Anwendungsbeispiel das Schemabild einer Klimaanlage,
          die durch Hilfsschütze gesteuert wird;

Fig. 7    die zugehörige Klemmenbelegungsliste für die Eingabe/
          Ausgabekarten;

Fig. 8    eine Darstellung des zur Klimaanlage gehörigen Stromlaufplanes;

Fig. 9    der zu der Klimaanlage gehörige Programmierungsplan;

Fig. 10, 11 und 12 Beispiele für den entsprechenden Programmausdruck
    des Programmdruckers;

Fig. 13    eine als Steuerkarte arbeitende Steckkarte; und

Fig. 14    die Frontansicht zweier nebeneinander angeordneter
    Steuerkarten gemäß Fig. 13.

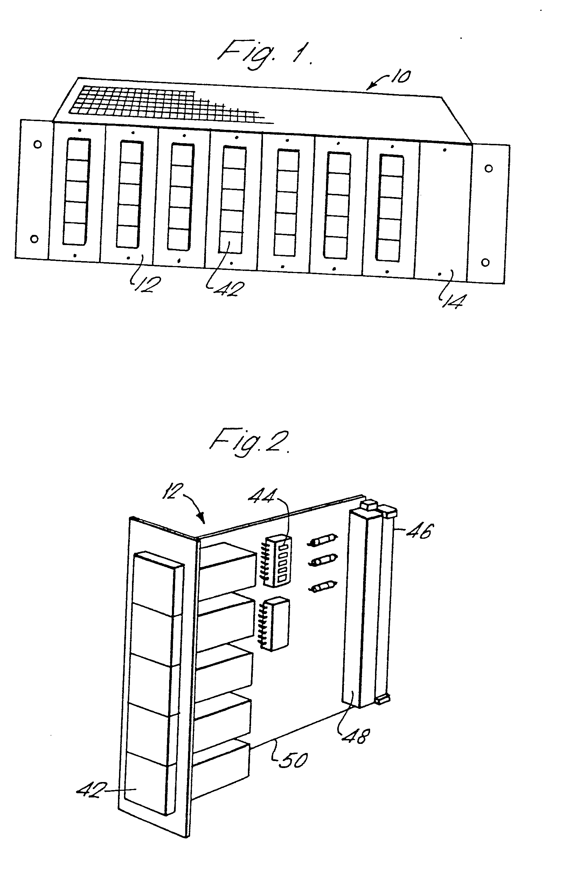

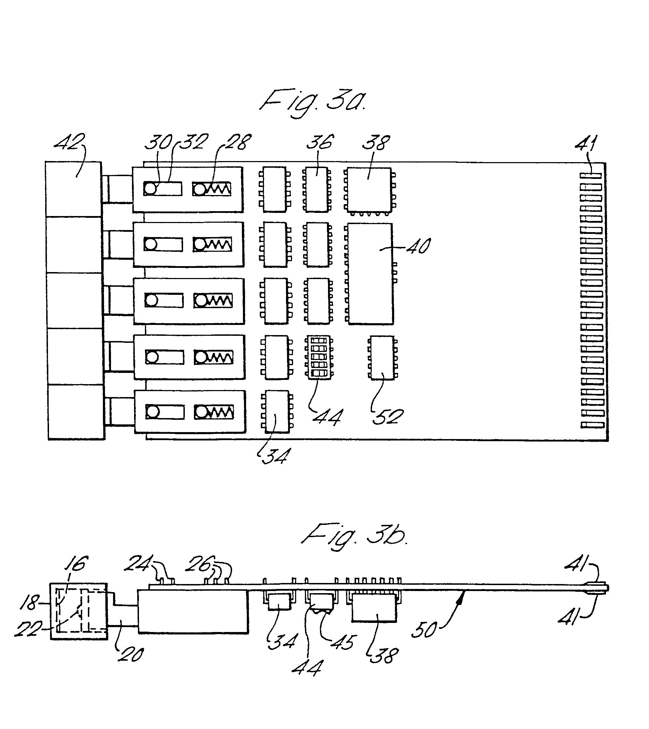

In Fig. 1 ist in perspektivischer Ansicht eine Steuereinheit 10
dargestellt, die aus einem Gehäuse besteht, welches hier sieben
gleichartige steckkartenartige Anzeige- und Bedienungselemente 12
aufweist, von denen eines in Fig. 2 perspektivisch in größeren
Einzelheiten dargestellt ist, außerdem ist in Fig. 1 noch eine
etwas anders gestaltete Einschubeinheit 14 wiedergegeben, die
beispielsweise einen Mikroprozessor trägt.

Die Steuereinheit 10 kann mit weiteren Steuereinheiten in üblicherweise z. B. einem Schaltschrank, nicht dargestellt, untergebracht werden, der außerdem die sonst noch für die Steuerung
der zugehörigen Anlage erforderlichen Elemente enthält, wie
Netzeinspeisung, Überwachungsmeßgeräte, Leistungsschütze, Hilfsleistungsschütze, Verriegelungseinrichtungen u. dgl.

Die dargestellten Anzeige- und Bedienungselemente 12 weisen
fünf neben- bzw. übereinander angeordnete dicht aneinanderliegende viereckige Leuchtdrucktasten 42 auf, wobei jeder einzelnen
Drucktaste 42 eine bestimmte Funktion zugeordnet ist, die durch
eine entsprechende Leuchtbeschriftung auf der Frontfläche des
Drucktastknopfes vermerkt werden kann, siehe Fig. 5, z. B. in
einfachster Weise durch mit schwarzer Tusche beschriftetes
durchscheinendes Papier 16, das von einer durchsichtigen Acrylglaskappe 18 geschützt wird, welche gleichzeitig den durch einen
Finger ausgeübten Bedienungsdruck auf z. B. ebenfalls aus Kunststoff gefertigten Betätigungsschieber 20 überträgt (Fig. 3b),
auf den die Kappe 18 aufsteckbar ist. Der Betätigungsschieber
weist in seinem Inneren eine (nicht dargestellte) Fassung auf,

0011119

in die eine Signallampe oder Leuchtdiode 22 einsteckbar ist.
Die Anschlüsse dieser Signallampe 22 sind an z. B. zwei Stifte 24
geführt, über die eine elektrische Verbindung mit der Druckplattenschaltung der Druckplatte 50 möglich ist.

Jede Drucktaste besitzt hier einen zweipoligen Umschaltkontakt,
dessen zweimal drei Anschlüsse ebenfalls über Stifte 26 mit
der Druckplattenschaltung elektrisch verbunden werden können.
Die Stifte 24 und 26 können zweckmäßigerweise auch gleichzeitig
als mechanische Befestigungseinrichtungen für den Taster auf
der Druckplatte 50 dienen.

Wie insbesondere aus Fig. 3a hervorgeht, werden die Drucktasten
durch eine Feder 28 nach außen in Ruhestellung gedrückt, wobei
der mit dem beweglichen Teil verbundene Anschlagzapfen 30 gegen
das eine Ende eines im festen Teil des Tasters befindlichen
Schlitzes 32 anliegt. Durch Fingerdruck kann die Taste gegen
die Kraft der Feder 28 soweit eingeschoben werden, daß der
Zapfen 30 am anderen Ende des Schlitzes 32 sich anlegt. Die
beiden Endstellungen der Taste entsprechen den zwei Stellungen
der zu diesem Taster gehörenden Umschaltkontakte.

Die Steckkarte 50 trägt neben den Leuchtdrucktasten noch als
Speicher wirkende Flipflop-Kreise 34, und zwar bei der dargestellten Ausführungsform für jede Leuchtdrucktaste 42 einen
Flipflop 34. Diese Speichereinheiten dienen dazu, das durch
das Eindrücken einer Taste eingegebene Signal solange zu speichern, bis dieses Signal durch eine erneute Betätigung der gleichen Drucktaste wieder gelöscht bzw. durch ein anderes Signal
ersetzt wird. Diese Speicherart gilt insbesondere dann, wenn
die zugehörige Leuchtdrucktaste als Bedienungselement arbeitet.
Dient sie dagegen lediglich als Anzeigeelement, arbeitet der
zugehörige Flipflop 34 in der Weise, daß er das zur Anzeige
zu bringende impulsförmige Signal speichert und die Lampe 22
veranlaßt, zu leuchten, solange nicht durch einen weiteren Signalimpuls der Zustand des Speichers bzw. Flipflops 34 wieder geändert wird und die Lampe erlischt oder - bei komplizierteren Schaltungen - Blinkbetrieb aufnimmt.

Ein derartiger Blinkbetrieb könnte beispielsweise durch einen oder mehrere integrierte Schaltkreise 36 verwirklicht werden, welcher bei entsprechender Ansteuerung ein oszillierendes Impulssignal abzugeben in der Lage wäre.

Um die Leuchtelemente 22, seien es nun Leuchtdioden, Glühlampen, Glimmlampen o. dgl. mit der notwendigen Betriebsenergie zu versorgen, wird zweckmäßigerweise auf der Druckplatte 50 auch ein Lampentreiber 38 angeordnet, der die zum Betrieb der verschiedenen Lampen erforderliche Energie unter der Steuerung der Datensignale liefert. Die zum Betrieb dieses Treibers und der Leuchtdrucktastenlampen erforderliche Energie kann der Druckplatte 50 über einen der verschienen Anschlußkontakte 40 zugeführt werden, beispielsweise in Form einer 12 V-Gleichspannung.

Auf der Druckplatte ist weiterhin eine Mikroschaltergruppe 44 zu erkennen, die im dargestellten Fall aus fünf miniaturisierten Umschalterkontakten besteht, die durch kleine Wippen 45 von Hand umgestellt werden können.

Statt der Codierschalter könnten auch entsprechende Steckbrückeneinrichtungen verschiedener Codierung verwendet werden.

Im vorliegenden Falle stehen die einzelnen Anzeige- und Bedienungselemente mit einem Mikroprozessor in Verbindung, der gleichzeitig mehrere Druckplatten versorgt. Aus diesem Grund weisen die entsprechenden Druckplatten jeweils noch einen Multiplexer 40 sowie einen Adressencodeeinsteller 52 auf, mit dessen Hilfe die Einzelabtastung nicht nur der verschiedenen vom Mikroprozessor anzusteuernden Karten (über den Adressencodeeinsteller 52), sondern auch der einzelnen Tasten (über den Multiplexer 40) ermöglicht wird. Die zyklische Abtastung durch einen Mikroprozessor ist an sich bekannt, so daß nicht näher auf den Vorgang eingegangen zu werden braucht, es sei nur erwähnt, daß der Multiplexer wie ein Drehschalter arbeitet, der unter der Steuerung eines Taktgebers im Mikroprozessor nacheinander den Multiplexerausgang, der mit dem Mikroprozessor verbunden ist, mit den verschiedenen Tasten 42 bzw. deren zugehörigen Speichern 34 verbindet, um die gespeicherten Daten abzufragen und an den Mikroprozessor weiterzuleiten bzw. vom Mikroprozessor gelieferte Daten in den Speicher 34 einzuschreiben.

Die Funktion der Speicher 34 kann übrigens auch vom Mikroprozessor selbst übernommen werden, da die Zykluszeit des Mikroprozessors so kurz ist, daß ein auch nur momentanes Niederdrücken einer der Leuchttasten wesentlich länger als eine Zykluszeit dauert, so daß die Tatsache des Tastenniederdrückens vom Mikroprozessor innerhalb der Zykluszeit erkannt und entsprechend in seinem eigenen Speicher gespeichert werden kann. In diesem Falle können die Speicherelemente 34 auch entfallen. Auch die Funktion der integrierten Schaltkreise 36 könnte ohne weiteres vom Mikroprozessor übernommen werden, so daß auch diese Schaltkreise 36 entfallen könnten.

Sogar die Funktion der Miniaturschaltergruppe 44 könnte durch eine entsprechende Programmierung des Mikroprozessors übernommen werden, d. h., daß durch entsprechende Software im Mikroprozessor festlegbar ist, welche der fünf (oder auch mehr) Tasten beispielsweise lediglich als Signalelemente dienen, welche anderen Tasten als Bedienungselemente arbeiten und wie sich die einzelnen Tasten gegenseitig in ihrer Funktion beeinflussen (d. h. sich gegenseitig auslösen). Damit reduziert sich ggf. die Bestückung der Druckplatte 50 auf das Treiberelement 38, den Multiplexer 40 und den Adressencodeeinsteller 52, der beispielsweise in der Form wiederum einer Miniaturschaltergruppe oder Codiersteckbrücke vorliegen kann.

Es ergibt sich ein außerordentlich einfacher Aufbau des Anzeige- und Bedienungselementes, weil die einzelnen Elemente völlig identisch fabriziert werden können und es lediglich vom Hersteller oder späteren Anwender noch erforderlich ist, die Funktion der einzelnen Leuchtdrucktasten dadurch festzulegen, daß eine entsprechende Umschaltung z. B. der Miniaturschaltergruppen 44,
52 bzw. Programmierung des Mikroprozessors erfolgt. Außerdem
wären noch die entsprechenden Beschriftungen 16 in die Leuchtdrucktasten 42 einzulegen und die Kappen 18 aufzustecken. Die
Programmierung des Mikroprozessors ist mit handelsüblichen
Einrichtungen ohne Schwierigkeiten durchzuführen, auf die näheren
Arbeitsweisen wird noch eingegangen.

Die einzelnen Steckkarten besitzen an ihrem Hinterende beidseitig
der Druckplatte Anschlüsse 41, beispielsweise insgesamt 40 Stück.
Durch Einstecken der Druckplatte in eine entsprechende Buchse
ergeben sich elektrische Verbindungen zwischen diesen Anschlüssen
40 und der innerhalb des Gehäuses 10 befindlichen Verdrahtung.
In Fig. 2 erfolgt die Verbindung zwischen Druckplatte 12 und
der Verdrahtung über einen Stecksockel 46 und eine Stiftleiste 48.

Die Stecksockel 46 der verschiedenen im Gehäuse 10 befindlichen
Steckkarten 12 können durch die Anwendung des Mikroprozessors
in einfacher Weise jeweils zueinander parallelgeschaltet werden,
so daß sich auch die Verdrahtung innerhalb des Gehäuses außerordentlich einfach gestaltet, da lediglich alle vorhandenen
steckkartenartigen Anzeige- und Bedienungselemente 12 bezüglich
ihrer einzelnen Kontakte 40 parallelgeschaltet werden müssen.

Wie in Fig. 1 dargestellt ist, können im Gehäuse z. B. sieben
identische Anzeige- und Bedienungselemente 12 mit jeweils fünf
Leuchtdrucktasten 42 untergebracht werden, während der noch
verbleibende freie Raum von einer weiteren Steckkarte 14 eingenommen wird, der ein Netzteil, den Mikroprozessor oder wieder
Leuchtdrucktasten trägt.

Das erfindungsgemäße Anzeige- und Bedienungselement ist für
sehr verschiedenartige Anwendungszwecke geeignet, besonders
günstig ist jedoch die Verwendung in einem freiprogrammierbaren
Steuerbausteinsystem, insbesondere für eine Klimaanlage, wie
im folgenden anhand eines besonderen Beispiels näher erläutert
wird.

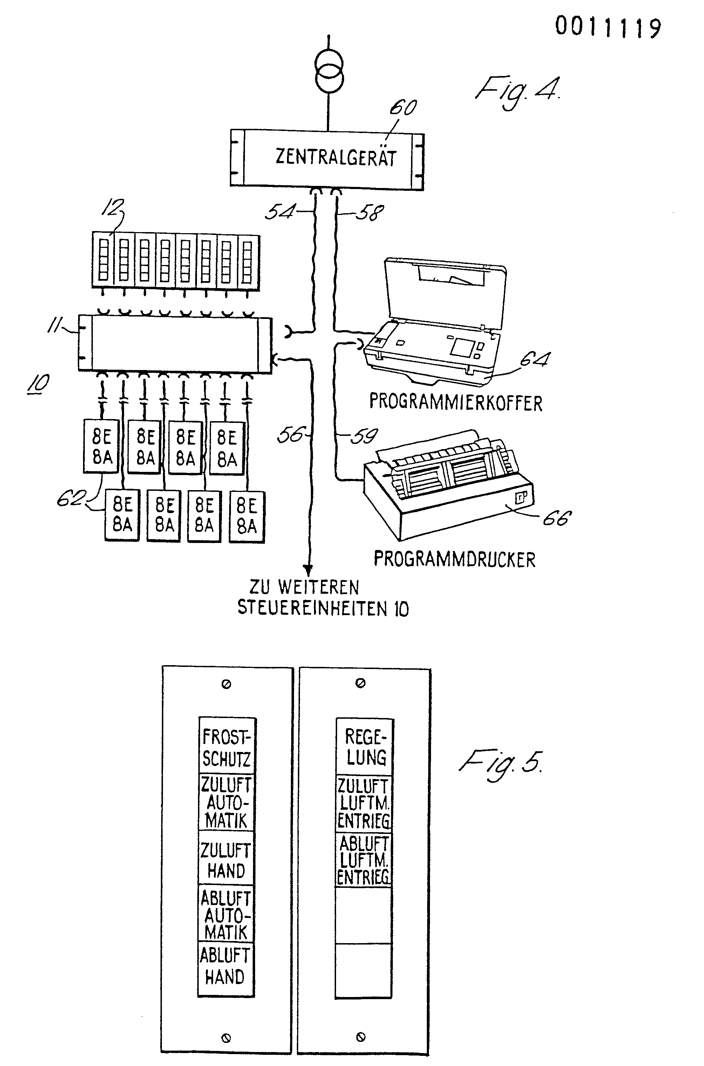

Ein derartiges Steuerungssystem besteht, siehe insbesondere
Fig. 4, z. B. aus einem Zentralgerät 60, das über eine Datensammelschiene (Datenbus) 54 mit einer ersten Steuereinheit 10,
die in einem Rahmen 11 bis zu insgesamt acht Anzeige- und Bedienungselemente 12 der vorstehend beschriebenen Art enthält,
und über die Weiterführung der Datenbus 54, Datenbus 56 mit ggf.
weiteren zweiten, dritten und vierten Steuereinheiten (nicht
dargestellt) von identischem Aufbau wie die Steuereinheit 10
verbunden ist.

Eine weitere Datenbus 48 führt gemäß Fig. 4 zu einem Programmierkoffer, der seinerseits über eine Datenbus 59 mit einem Programmdrucker in Verbindung steht.

Wie sich aus der schematischen Darstellung der Fig. 4 ergibt,
sind die bis zu acht Anzeige- und Bedienungselemente 12 in Form
von Steckkarten in einen Einbaurahmen 11 (z. B. 19 Zoll-Format)
gesteckt, an dem auch die Datenbus 54 und 56 angeschlossen ist.
Des weiteren stehen mit dem Einbaurahmen 11 noch weitere acht
Steckkarten 62 in Verbindung, die Eingabe/Ausgabeeinrichtungen
enthalten. Diese Ein- und Ausgabekarten dienen als Schnittstelle
zwischen dem Steuerungssystem und der zu steuernden Anlage,
die hier nicht dargestellt ist. Jede Ein- und Ausgabekarte 62
besitzt acht Eingänge (8E) und acht Ausgänge (8A).

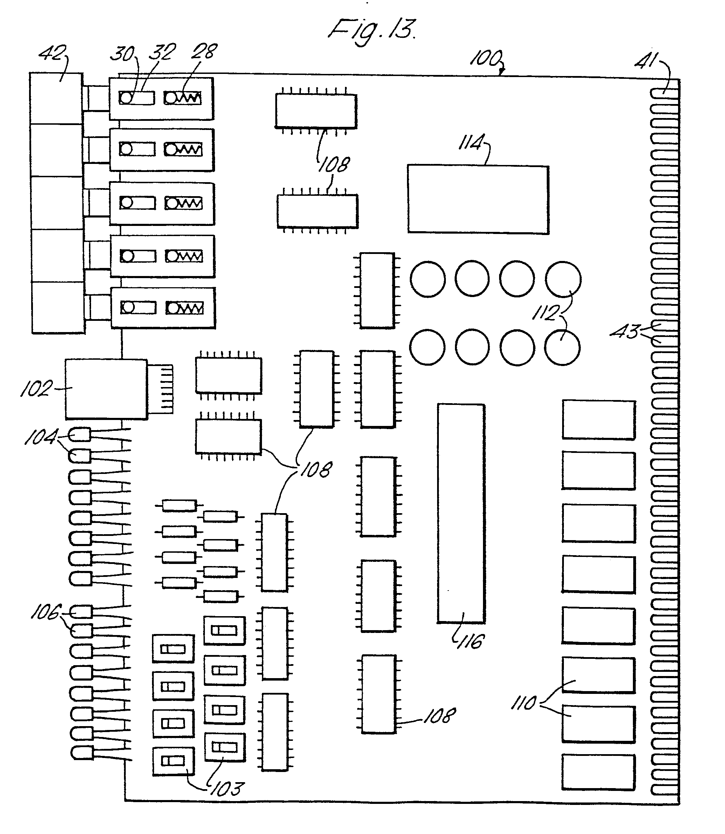

Statt, wie in Fig. 4 schematisch dargestellt, die Anzeige- und
Bedienungselemente 12 sowie die Ein- und Ausgabekarten 62 als
getrennte, in einen Einbaurahmen 11 einzusteckende Karten auszubilden, ist es möglich, jeweils ein Anzeige- und Bedienungselement 12 mit jeweils einer Ein- und Ausgabekarte 62 zu einer
"Steuerkarte" zu vereinigen, was den Vorteil hat, daß sich die
Anzahl der Steckkarten, die in dem Einbaurahmen 11 unterzubringen
sind, auf die Hälfte reduziert und dadurch zum einen die Verdrahtung im Einbaurahmen sich vereinfacht und auch die erforderliche Anzahl der Steckkontakte sich verringert. Die so geschaffenen Steuerkarten können wieder in sich identisch aufgebaut werden, z. B. in der in Fig. 13 schematisch dargestellten Form.

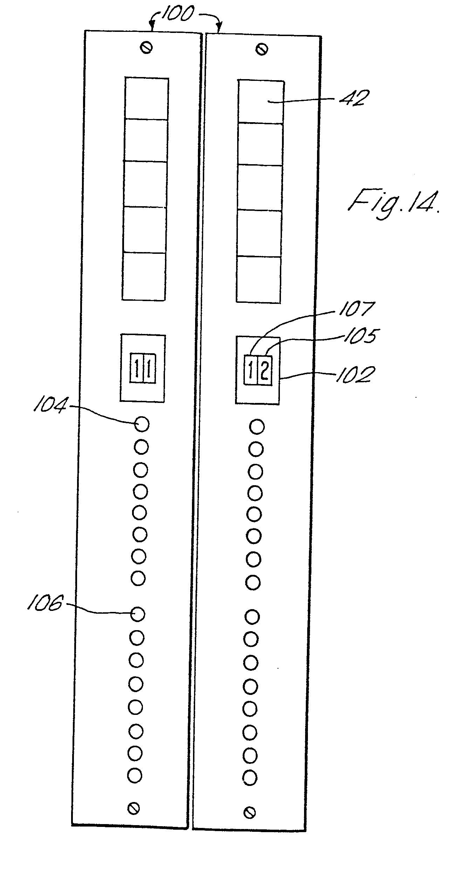

Die dort dargestellte Steuerkarte 100 umfaßt wieder eine Druckplatte von gegenüber der in Fig. 3a dargestellten Ausführungsform größeren Ausmaßen, mit wiederum fünf nebeneinander angeordneten Leuchtdrucktasten 42, die identisch wie bei der in
Fig. 3a dargestellten Ausführungsform ausgebildet sein können
und z. B. am oberen Ende der Frontkante der Druckplatte angeordnet sind. Ebenfalls an der Frontkante unterhalb der Drucktaste 42 befindet sich ein Adressierschalter 102, mittels dem
eine Adresse für diese Steuerkarte 100 einstellbar ist, unter
der diese Steuerkarte von dem Zentralgerät 60 angerufen werden
kann. Da bei dem in Fig. 4 dargestellten System mehrere Steuereinheiten 10 mit jeweils bis zu acht Steuerkarten 100 vorgesehen
sind, besitzt der Adressierschalter 102 zwei Einstellräder 105,
107, mit denen die Ziffern 1 bis 8 jeweils eingestellt werden
können. Das eine Einstellrad 107 kennzeichnet dabei die jeweilige
Steuereinheit 10, während das zweite Rad 105 die jeweilige Steuerkarte 100 der Steuereinheit 10 kennzeichnet. Die eingestellte
Codierung ist nach außen hin sichtbar (Fig. 14).

Unterhalb des Codierschalters 102 befinden sich zwei Gruppen
von jeweils acht Leuchtdioden 104, 106, wobei die Leuchtdioden 104
beispielsweise grün gefärbt sind und den Zustand von acht externen Eingängen kennzeichnen, während die Leuchtdioden 106 z. B.
rot gefärbt sein können und Zustandsanzeigen für acht externe
Ausgänge darstellen. Die für die Steuerung der Leuchtdioden und
Leuchtdrucktasten notwendigen Treiber, weiterhin Verknüpfungsschaltungen und Speichereinrichtungen sind durch zahlreiche
integrierte Bausteine verwirklicht, die in Fig. 13 mit 108 bezeichnet sind. Des weiteren ist auf der dargestellten Steuerkarte 100 ein Satz von acht Relais 110 zu erkennen, die zur
Betätigung von externen Schaltschützen u. dgl. dienen und eine
galvanische Trennung zwischen den Steuerkreisen der Steuerkarte
100 und den an die zu steuernde Anlage gelieferten Steuersignalen
bewirken. Eine ähnliche galvanische Trennung ist auch zwischen
den externen Eingangssignalen und den Signalen der Steuerkarte
100 vorgesehen, und zwar hier in Form von acht Optokopplern 112.
Diese galvanische Trennung zwischen den externen Eingangs- und

0011119

Ausgangssignalen und den internen Signalen der Steuerkarte 100
selbst dient zum einen Sicherheitsgründen, zum anderen sind
die Steuerpotentiale üblicherweise stark unterschiedlich, wobei
die von Sensoren u. dgl. eingehenden externen Eingangssignale
wie auch die an die zu steuernde Anlage abgegebenen externen
Ausgangssignale Wechselstromsignale mit einer Spannung von z. B.
220 V sind, während die zwischen den Bauelementen der Steuerkarte 100 fließenden Signalspannungen in der Größenordnung von
z. B. 20 V liegen.

Ebenfalls aus Gründen der galvanischen Trennung besitzt die
Steuerkarte 100 ein eigenes Stromversorgungsteil 114, das eine
über einen der Anschlußkontakte 43 geführte Wechselspannung
von beispielsweise 24 oder 220 V in die für den Betrieb der
Bauelemente der Steuerkarte 100 benötigte Gleichspannung von
z. B. 12 oder 20 V umwandelt.

Bei der dargestellten Ausführungsform sind die Anschlußkontakte
unterschiedlich bemessen, wobei die schmäleren Anschlußkontakte 41
als Verbindungsanschlüsse für die Datenbus 54 und 56 dienen,
während die breiteren Anschlüsse 43 höhere Ströme führen können
und dazu dienen, von dem zu steuernden System Eingangssignale
aufzunehmen und an dieses System auch Ausgangssignale abzugeben.

Die Steuerkarte 100 weist noch eine Steckleiste 116 für einen
Satz von durch Hardware gebildete Zeitglieder auf, deren Funktion
im folgenden noch näher erläutert werden wird.

Schließlich sind noch acht Prüfschalter 103 zu erkennen, die dazu
dienen, anstelle von von der Elektronik gelieferten Signalen von
Hand einstellbare Signale zu Prüfzwecken den Ein- und Ausgabe-
elementen der Steuerkarte zuzuführen.

Fig. 14 zeigt zwei nebeneinander in einen nicht dargestellten
Einbaurahmen eingesetzte Steuerkarten 100, wobei der Codierschalter 102 der einen Steuerkarte die Codierung 11 und die andere
die Codierung 12 zeigt.

Für die nun folgende mehr ins einzelne gehende Beschreibung
sei darauf hingewiesen, daß die Eingangsklemmen der verschiedenen
Eingänge mit E1, E2 ... E7, E8 und die Ausgangsklemmen jeweils
mit A1, A2 ... A7, A8 (Fußpunkt des Relais), 10, 20 ... 70, 80
(Öffner des Relais) bzw. 11, 21 ... 71, 81 (Schließer des Relais)
bezeichnet sind. Die Adressierung der Ein- oder Ausgänge erfolgt
z. B. in der Form, daß der erste Eingang der ersten Steckkarte
mit 1E1, der fünfte Eingang der ersten Steckkarte mit 1E5, der
siebte Eingang der sechsten Steckkarte mit 6E7, der dritte Ausgang der ersten Steckkarte mit 1A3 usw. bezeichnet ist.

Die Realisierung der verschiedenen konventionellen Steuerschalterfunktion durch das aus den neuartigen Anzeige- und Bedienungselementen aufgebaute Steuerungssystem erfordert im Zentralgerät
gespeicherte Software. Von diesem Software-Programm wird jede
Taste als Eingang, jede Lampe als Ausgang behandelt. Entsprechend erfolgt die Adressierung in der Weise, daß z. B. die Taste 1
in der ersten Steckkarte oder Steuerkarte mit E1, die Taste 5
in der ersten Karte mit E5, die Taste 5 in der zweiten Karte
mit E10, die Lampe 1 in der ersten Karte mit A1, die Lampe 5
in der ersten Karte mit A5, die Lampe 5 in der zweiten Karte
mit A10 usw. bezeichnet wird.

Folgende Steuerschalterfunktionen werden zweckmäßigerweise
softwaremäßig gespeichert und je nach Anlagenkonfiguration
einzelnen Bedienungskarten, auch in beliebiger Reihenfolge,
zugeordnet:

1. Keine gegenseitige Auslösung der Tasten, d. h. jede Taste
   arbeitet unabhängig: einmal drücken = ein; nocheinmal
   drücken = aus;

2. zwei Tasten lösen sich gegenseitig aus; drei Tasten sind
   unabhängig;

3. zwei Tasten lösen sich gegenseitig aus; zwei weitere Tasten
   lösen sich gegenseitig aus; eine Taste ist unabhängig;

4. zwei Tasten lösen sich gegenseitig aus; drei Tasten lösen
   sich gegenseitig aus;

5.  drei Tasten lösen sich gegenseitig aus; zwei Tasten sind
    unabhängig;

6.  vier Tasten lösen sich gegenseitig aus; eine Taste ist
    unabhängig;

7.  fünf Tasten lösen sich gegenseitig aus.

Die Wahl, welche dieser Funktionen jeder Bedienungssteckkarte
zugeordnet wird, erfolgt bei der Anlagenkonzipierung. Eine mögliche Programmierung kann u. U. auf jeder Bedienungskarte durch
drei Codierschalter in binärer Form geschehen.

Ein- und Ausschalten eines externen Ausganges erfolgt über die
gleiche Taste. Mit sich gegenseitig auslösenden Tasten können
Funktionen wie "Handautomatik" oder "Automatik - Stufe 1 -
Stufe 2" usw. realisiert werden. Bei diesen Programmen erfolgt
das Ausschalten durch Betätigung der gesetzten Taste.

Da alle Tastenbefehle nur als Impulse eingegeben werden, muß
in einem internen Speicher dieser Impuls als statischer Befehl
abgelegt werden. Bei jeder Impulsgabe ändert sich somit der
Speicherzustand (Flipflop-Funktion). Gesetzter Zustand ändert
sich somit entweder durch Betätigen der gleichen Taste (bei
keiner gegenseitigen Auslösung) oder durch Betätigen einer
anderen Taste (bei gegenseitiger Auslösung). Bei Betätigen von
mehreren Tasten gleichzeitig erfolgt keine Zustandsänderung.

Die Speicherplätze, die von den Tasten belegt sind, müssen
ständig dem Anwenderprogramm als Zustandsinformation zur Verfügung stehen. Die Adressierung dieser Speicherplätze erfolgt
genau wie bei den Tasten mit E1, E2 ... En.

Da die Tasten auch u. U. nur als Impulsgeber gebraucht werden,
muß die Möglichkeit bestehen, über das Anwenderprogramm aus
dem Haftspeicher (ROM-Speicher) in einen nichthaftenden Speicher
(RAM-Speicher) einzugeben.

Sämtliche Tasten können über Schlüsselschalter im Zentralgerät funktionslos geschaltet werden. Der Speicherzustand bleibt dabei erhalten.

Werden die Leuchttasten nur als Meldelampe benutzt, werden die Tastenspeicherplätze nicht abgefragt.

Da bei der dargestellten Ausführungsform die Maximalbestückung des Steuersystems aus 160 Tasten bestehen kann, muß der Speichervorrat für die Tastenfunktionen ebenfalls mindestens 160 Plätze betragen.

Die Zentraleinheit 60, die in Fig. 4 dargestellt ist, kann beispielsweise einen Schlüsselschalter für die Netzversorgung, einen Schlüsselschalter zum Unwirksammachen aller Tasten, einen Drucktaster für den Lampentest (bei Betätigung leuchten sämtliche Meldelampen des Systems auf, um zu kontrollieren, ob sämtliche Lampen funktionsfähig sind), und weitere Leuchttaster enthalten, die für weitere Zwecke verwendbar sind, beispielsweise um einen Eingang (z. B. EO) dem Speicher zu liefern.

Des weiteren enthält das Zentralgerät 60 einen 8-Bit-Mikroprozessor (beispielsweise vom Typ Motorola der Familie 6800), kombiniert mit einem 1-Bit-Mikroprozessor (z. B. aus der Motorola Familie 14500).

Des weiteren ist ein Speicher für ein internes Arbeitsprogramm vorgesehen, dessen Inhalt auch bei Netzausfall unverlierbar ist (z. B. PROM-Speicher).

Außerdem ist ein Speicher für den frei programmierten Anteil vorgesehen, entweder in Form eines RAM-Speichers, batteriegepuffert, oder auch in Form eines PROM-Speichers mit unverlierbarem Inhalt.

Die RAM-Speicherkarte wird zum Austesten der Anlage benötigt, um Änderungen und Ergänzungen des Anwenderprogramms schnell und ohne Probleme vornehmen zu können. Der Speicherinhalt könnte

z. B. 4096 Worte betragen, wobei ein Wort gleich einer logischen Funktion ist.

Während diese RAM-Speicherkarte aus der Anlage wieder entfernt werden kann, verbleibt die PROM-Speicherkarte in der getesteten Anlage. Der Speicherinhalt der PROM-Speicherkarte sollte mindestens 1024 Worte (1024 logische Funktionen) betragen, doch sollten noch Leersockel zur Erweiterung auf z. B. mindestens 4096 Worte vorhanden sein.

Es ist zweckmäßig, über eine Pufferbatterie sicherzustellen, daß bei Netzausfall der letzte Impuls der Bedienungstasten gespeichert wird (die Lampen gehen hierbei allerdings aus). Dadurch kehrt bei Netzwiederkehr auch die vorgewählte Tastenfunktion zurück.

Für eine Dezentralisierung des Schaltschrankes sollte außerdem die Möglichkeit vorgesehen werden, den Datentransfer über eine externe Ringleitung (Koaxialkabel) vorzunehmen, siehe die Patentanmeldung P 28 22 938.1. Die zu übertragende Datenwortstruktur sollte mindestens zwölf Bitworte (Auflösung von Prozeß ADU) plus Vorzeichenbit sein. Daraus resultiert eine Wortlänge von 16 Bit. Bei dieser weiterentwickelten Version entfallen die Eingabe/Ausgabekarten, die schaltschrankexterne Befehle umsetzen.

Das Zentralgerät 60 besitzt verschiedene Software-Pakete. So ist z. B. fest abgespeichert ein internes Selbstüberwachungsprogramm mit Stillstand bei Fehlermeldung, wobei der Störspeicher EO gesetzt wird. Gleichzeitig wird ein Reservegerät gestartet. Ist kein Reservegerät angeschlossen, werden alle Ausgänge auf einen definierten logischen Nullzustand gebracht.

Des weiteren ist der bereits erwähnte Lampentest in Form eines Programms abgespeichert, gemäß dem sämtliche Meldelampen des Systems für die Dauer der Betätigung des Tasters "Lampentest" aufleuchten.

Unter einer bestimmten definierten Adresse muß auch ein Blinkimpuls von z. B. 0,5 s Dauer mit einer 0,5 s Pause ständig abfragebereit anstehen.

Des weiteren sind noch Programme für logische Verknüpfungsbausteine vorgesehen, die anwenderbezogen programmiert werden,
siehe noch im folgenden die dazu gegebene nähere Erläuterung.

Mit Hilfe des in Fig. 4 dargestellten Programmiergerätes, bestehend aus dem Programmierkoffer 64 und dem Programmdrucker 66
lassen sich beispielsweise folgende Eingaben in das Zentralgerät
machen:

a)     Einschreiben von Belegungslisten in Klartext (pro Zeile
       bis 20 Buchstaben);

b)     Eingabe logischer Funktionen über jeweils eine Taste (jeweils UND; ODER; NICHT; HS = Hilfsspeicher; VR = Verriegelung; E = Eingang; A = Ausgang; ZIEL = auf Ausgang schalten;
       STR = Beginn eines neuen Strompfades);

c)     Adressenwahl (Zifferntastatur 0 bis 9);

d)     Löschen (löschen des Display);

e)     Lesen (Lesen eines Speicherplatzinhalts);

f)     Einfügen (Einfügen einer zusätzlichen logischen Funktion
       im Falle eines RAM-Speicherbetriebs);

g)     Drucken (Programm ausdrucken);

h)     Laden der Kassette mit Anwenderprogramm;

i)     Laden des E-PROM mit Anwenderprogramm für RAM-Speicher
       oder -Kassette; und

k)     Laden des Anwenderprogramms im Speicher.

Auf einer einzeiligen Darstellung (Display) wird angezeigt:
angewählter Speicherplatz im Anwenderbereich und außerdem die
logische Funktion des angewählten Speicherplatzes und ein eingeschriebenes Wort im Klartext bis 16 Buchstaben.

Jeder logischen Funktionstaste ist eine LED (Leuchtdiode) zugeordnet, die bei Anwahl eines Speicherplatzes die Programmeingabe optisch anzeigt.

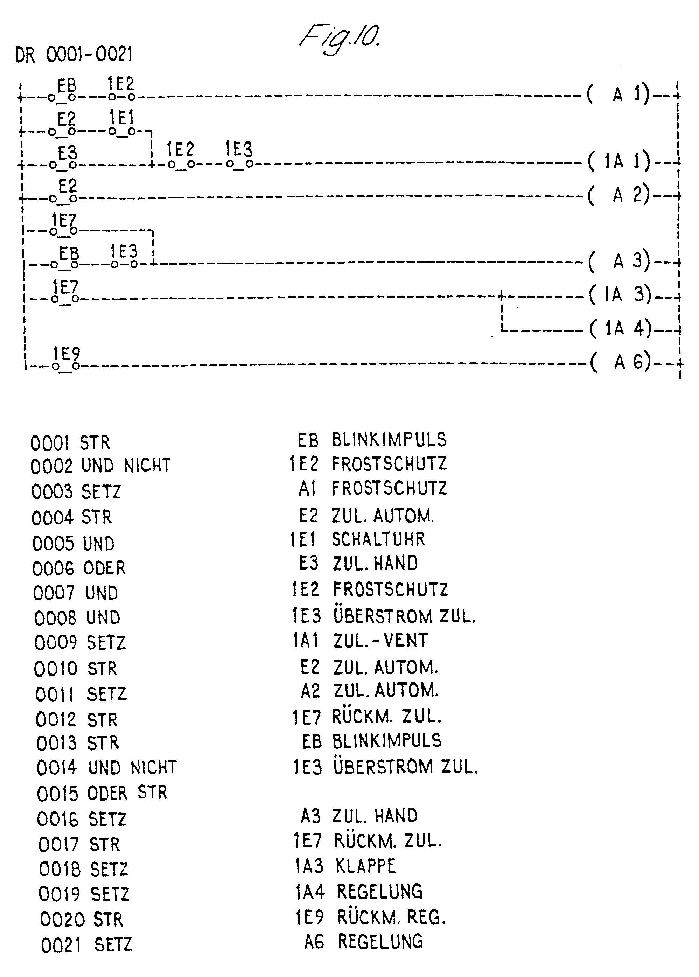

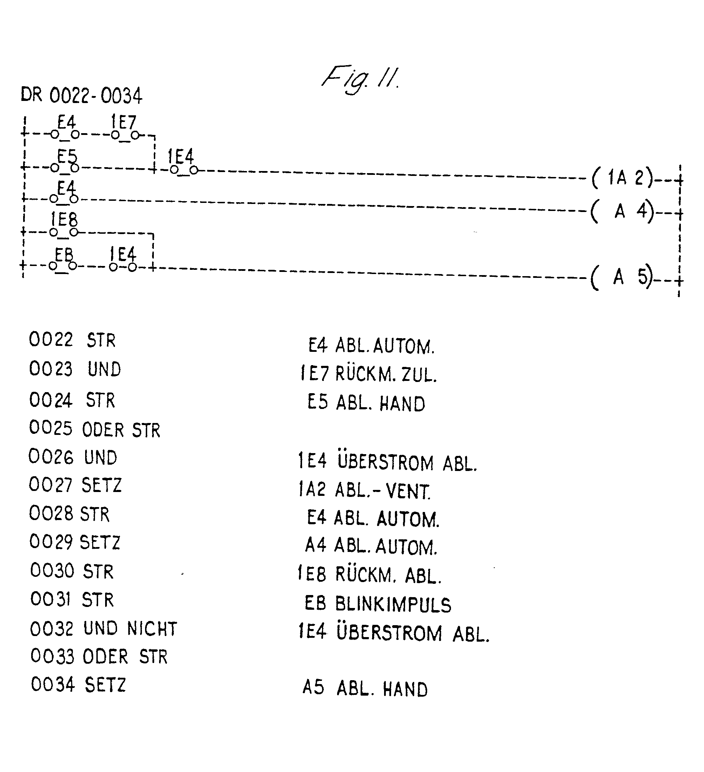

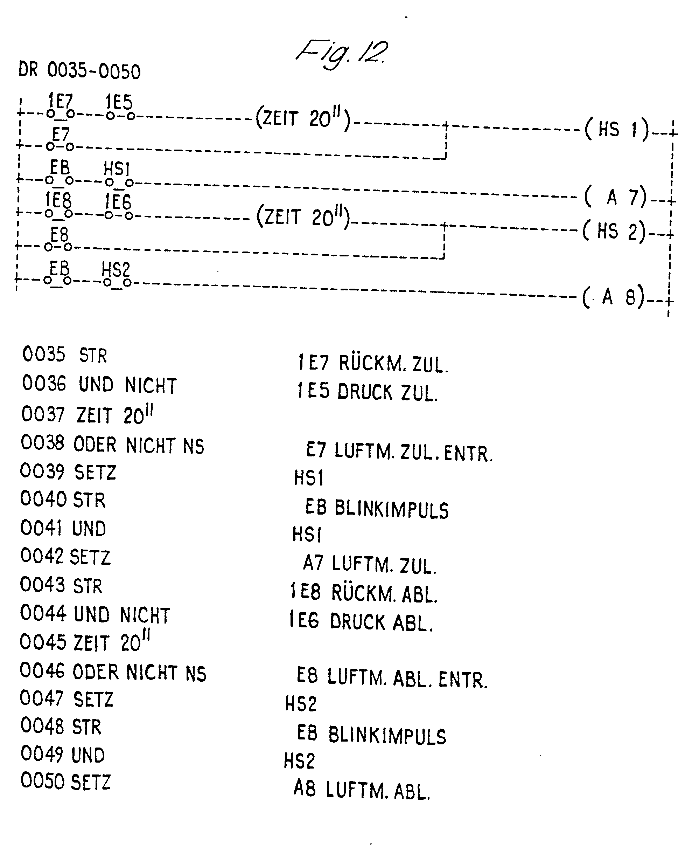

Das Anwenderprogramm läßt sich auf Tastendruck "Drucken" über einen angeschlossenen Drucker (z. B. Nadeldrucker) in Form eines Stromlaufplans ausdrucken, siehe die Fig. 10 bis 12.

Das Programmiergerät besitzt ein eingebautes Kassettenlaufwerk zur Aufzeichnung des Anwenderprogramms einschließlich Belegungsliste.

Im folgenden soll die Handhabung des die erfindungsgemäßen Anzeige- und Bedienungselemente umfassenden Systems an einem Programmierbeispiel näher erläutert werden, wobei die Vorteile der freien Programmierbarkeit besonders deutlich werden.

Die Programmierung erfolgt mit Stromlaufplansymbolen. Als besonders anwenderfreundliche Programmierform hat sich das System 5TI der Firma Texas Instruments erwiesen, so daß diese Programmierform im folgenden zur Grundlage gemacht wird.

Folgende logische Verknüpfungen und Funktionen sind vorhanden:
UND = Reihenschaltung von zwei und mehr beliebigen Schließern
ODER = Parallelschaltung von zwei und mehreren Schließern
NICHT = Änderung in Öffner
ZEIT = Anwahl einer Zeitfunktion, wobei durch entsprechende Programmierung die Einschaltung oder Ausschaltung verzögert wird. Durch zusätzliches Programmieren einer Zeitdauer lassen sich auch variable Zeitabläufe verwirklichen. Rückstellung erfolgt durch das Anwenderprogramm. Beispielsweise sind Zeiten von 0,1 s bis 30 min vorgesehen, unter Anwendung von 256 Stück Zeitgliedern, die als Stecksatz in die in Fig. 13 dargestellte Steckleiste einsteckbar sein könnten, während die Zeitfunktionen nur softwaremäßig, also vom Programm her verwirklicht werden.

ZÄHLER = Anwahl einer Zählfunktion, wobei durch Programmierung sowohl vorwärts wie auch rückwärts gezählt werden kann. Durch weitere Programmierung ist auch eine Taktzahl mit variabler Zähldauer möglich. Rücksetzung auf 0 wiederum durch das Anwen-

- 22 -

derprogramm. Bei Verwendung von 64 Stück Zählgliedern ist ein Zählen von 1 bis 1024 möglich.

HS = Hilfsspeicher: Interner Speicher für das Anwenderprogramm. Dieser Hilfsspeicher ist ähnlich einem Steuerschütz bei konventionellen Anlagen. Die Hilfsspeicher sind beliebig oft abfragbar und sind beispielsweise in einer Anzahl von 1024 Stück vorhanden.

VR = Verriegelung: Programmieren einer Verriegelungsfunktion vor einer programmierbaren Anzahl von Ausgängen, wobei diese Ausgänge solange ausgeschaltet bleiben (auch wenn die ausgangseigene Funktion "wahr" ist), bis die Verriegelungsfunktion "wahr" wird.

Alle logischen Funktionen können durch das Anwenderprogramm beliebig oft abgefragt und in Verknüpfungsketten verwendet werden.

Die Fig. 6 zeigt anhand einer schematischen Darstellung das Beispiel einer zu projektierenden Klimaanlage. Ein durch das Schütz C1 einschaltbarer Zuluftventilator (siehe Spalte 14) wird bei Stellung des Schalter b2 in der Position "Automatik" eingeschaltet, wenn gleichzeitig der von der Zeitschaltuhr D3 abhängige Kontakt d3 geschlossen ist und gleichzeitig der von einem Überstromauslöser e5 betätigte Schütz D5 Kontakt d5 sowie eine weiterer Kontakt d4 geschlossen sind, der seinerseits von einem Schütz D4 betätigt wird, dessen Funktion von einem Frostschutzthermostaten e1 (Spalte 8) abhängt. Ist die Temperatur größer als $5^{o}$ C und ein Überstrom nicht vorhanden, sind die Kontakte d4 und d5 geschlossen und das Schütz C1 schließt auch den Kontakt c1 (Spalte 15) und bringt dadurch die Meldelampe für Zuluft, H2, zum Leuchten. Außerdem wird durch entsprechende Kontakte c1 in den Spalten 19 und 20 ein Klappenstellmotor betätigt und die Außenluftklappe geöffnet.

Der Abluftventilator (Spalte 26) schaltet sich über Kontakt c2 (Spalte 25), der vom Schütz C2 betätigt wird, ein, wenn durch Nichtvorhandensein eines Überstroms (Überstromsensor E8 und zugehöriges Schütz D6 in Spalte 22) der Kontakt d6 in Spalte 24 geschlossen ist und außerdem sich der Schalter b3 in der Stellung "Automatik" befindet und durch den eingeschalteten Zuluftventilator auch der in Zeile 23 dargestellte Kontakt c1 geschlossen ist. Gleichzeitig leuchtet die Meldelampe H3 "Abluft". Durch Umschaltung der Schalter b2 bzw. b3 auf die Schalterstellung "Hand" lassen sich die Ventilatoren auch unabhängig schalten.

Bei Frostgefahr (Temperatur niedriger als $5^\circ$ C) öffnet sich der in Spalte 8 dargestellte Sensorkontakt e1, wodurch sich der Kontakt d4 in Spalte 14 öffnet und in Spalte 9 der Kontakt d4 sich schließt, wodurch zum einen die Frostschutzlampe H1 aufblinkt und die Lüfter ausgeschaltet und die Außenluftklappe geschlossen wird. Spricht einer der Überstromauslöser E2, E3 an, schaltet der entsprechende Motor aus, die zugehörige Meldelampe blinkt.

Bei Betrieb des Zuluftventilators wird die Regelung über das in Spalte 29 dargestellte Hilfsschütz D7 freigegeben.

Die Druckschalter e4 und e5 (Spalten 33 und 39) überwachen den Luftstrom der Ventilatoren. Die Überwachung wird bei Einschalten des Ventilators nach 20 s freigegeben. Bei Ansprechen eines Druckschalters blinkt die zugehörige Meldelampe. Die Störmeldung muß mit Drucktaster wieder entriegelt werden.

Alle Meldelampen können mit dem Kontakt b1 "Lampentest" (Spalte 4) überprüft werden, uns zwar durch entsprechende vom Schütz D2 betätigte Kontakte d2 in Spalten 10, 17, 27, 31, 37 und 43.

Die Fig. 6 zeigt die im wesentlichen in konventioneller Weise hergestellte Klimaanlage.

Um diese Anlage mittels der erfindungsgemäßen Anzeige- und Bedienungselemente zu steuern, müssen zunächst die benötigten
Elemente ermittelt werden. Erforderlich sind:

| | |
|---|---|
| Frostschutz | 1 Lampe |
| Zuluft (Automatik/Hand) | 2 Leuchttaster |
| Abluft (Automatik/Hand) | 2 Leuchttaster |
| Regelung | 1 Lampe |
| Luftmangelzuluft | 1 Leuchttaster |
| Luftmangelabluft | 1 Leuchttaster. |

Es werden also insgesamt acht Leuchttaster benötigt, die von
zwei Anzeige- und Bedienungselementen geliefert werden, wie
sie in Fig. 5 oder 14 dargestellt sind, wobei zwei Leuchttaster
nicht belegt werden.

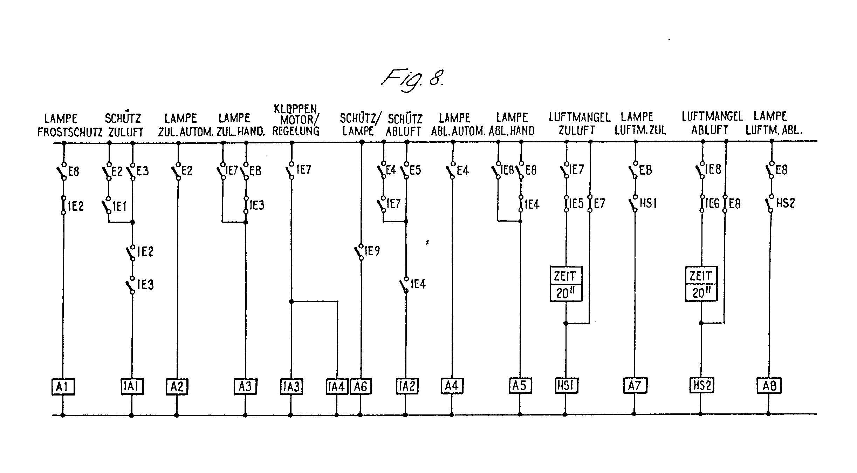

Fig. 8 zeigt als Schemadiagramm den Aufbau der Klimasteuerungsanlage mit den neuartigen Anzeige- und Bedienungselementen.
Dabei bedeuten:

EB Blinkimpuls

E2 Zul. Autom.

E3 Zul. Hand

E4 Abl. Autom.

E5 Abl. Hand

E7 Luftm. Zul. Entr.

E8 Luftm. Abl. Entr.

1E1 Schaltuhr

1E2 Frostschutz

1E3 Überstrom Zul.

1E4 Überstrom Abl.

1E5 Druck Zul.

1E6 Druck Abl.

1E7 Rückm. Zul.

1E8 Rückm. Abl.

1E9 Rückm. Reg.

A1 Frostschutz

A2 Zul. Autom.

A3 Zul. Hand

A4 Abl. Autom.

A5 Abl. Hand

A6 Regelung

A7 Luftm. Zul.

A8 Luftm. Abl.

1A1 Zul. Vent.

1A2 Abl. Vent.

1A3 Klappe

1A4 Regelung

Die oben angegebenen Adressen ohne Vorzahl sind Taster oder
Lampen. Adressen mit Vorzahl sind externe Ein- oder Ausgänge
über eine Eingabe/Ausgabe-Schalttafel. Durch die oben jeweils
gewählte Abkürzung der Erläuterung läßt sich erreichen, daß
die Belegungsliste jeweils nicht mehr als 20 Zeichen pro Zeile
aufweist.

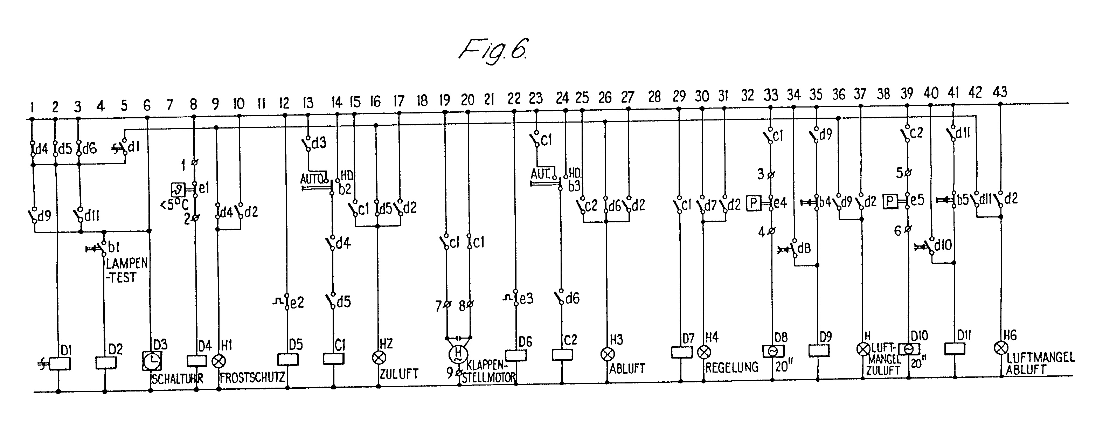

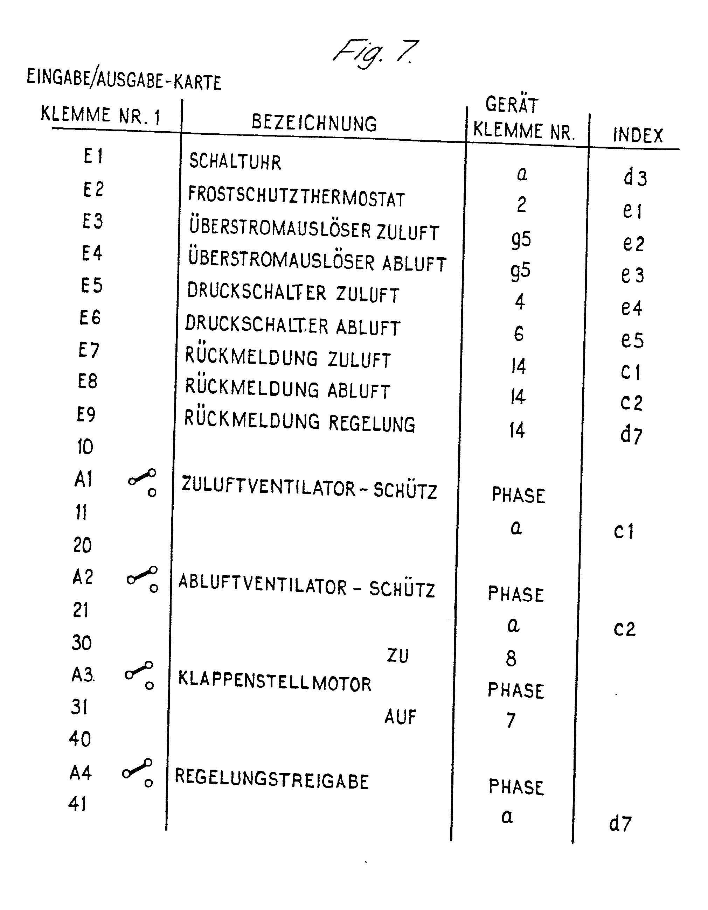

In Fig. 7 ist dargestellt, wie die Klemmenbelegung an der Ein-
gabe/Ausgabekarte (Fig. 4) oder der Steuerkarte (Fig. 13) erfolgen kann. Gemäß der Aufstellung dieser Fig. 7 erfolgt dann
auch die Verdrahtung im Schaltschrank, also die Herstellung
der Verbindungen zwischen der Eingabe/Ausgabe-Steckkarte (bzw.
Steuerkarte) und den entsprechenden Schützkontakten oder Ausgangsklemmen. Bei der Erstellung des in Fig. 8 dargestellten
Funktionskonzeptes in Form eines Stromlaufplanes sind die entsprechenden Adressennummern erkennbar. Dabei ist berücksichtigt,
daß der Blinkimpuls unter der Adresse EB bereitsteht, während
der Lampentest generell vorgesehen ist und daher nicht besonders programmiert zu werden braucht.

Mittels des Programmiergerätes 64, 66, siehe Fig. 4, läßt sich
nun schrittweise anhand der Ein- und Ausgangsbelegungslisten
sowie des Funktionskonzeptes (Fig. 7 und 8) das Anwenderprogramm
abspeichern. Dies geschieht in zwei Stufen:

a)   Einschreiben der Eingabe/Ausgabebelegungsliste Zeile für
     Zeile in Klartext in den internen RAM-Speicher des Programmiergerätes, wobei eine ständige Kontrolle des Geschriebenen auf der Darstellung des Gerätes möglich ist. Einschließ-

- 26 -                              0011119

lich der Leertaste sind, wie bereits ausgeführt, pro Zeile
20 Zeichen bei üblichen Programmiergeräten möglich. Auch
Änderungen, Erweiterungen und Einfügungen von Zeilen sind
möglich. Es können bei diesem Gerät maximal 1024 Zeilen
abgespeichert werden.

b)   Dann wird das Funktionskonzept über die Tasten mit logischen
     Symbolen in den für das Austesten der Anlage vorgesehenen
     RAM-Speicher im Steuerungssystem geladen. Auch hier sind
     Änderungen, Erweiterungen und das Einfügen von Worten möglich. Auf der Darstellung des Programmiergerätes kann stän-
     dig kontrolliert werden, welche Funktionen in welchen Spei-
     cherplätzen stehen. Über LED-Anzeigen in den Funktionstasten
     kann sofort erkannt werden, ob der Speicherplatzinhalt
     "wahr" ist oder nicht. Speicherplätze können beliebig gelöscht oder überschrieben werden.

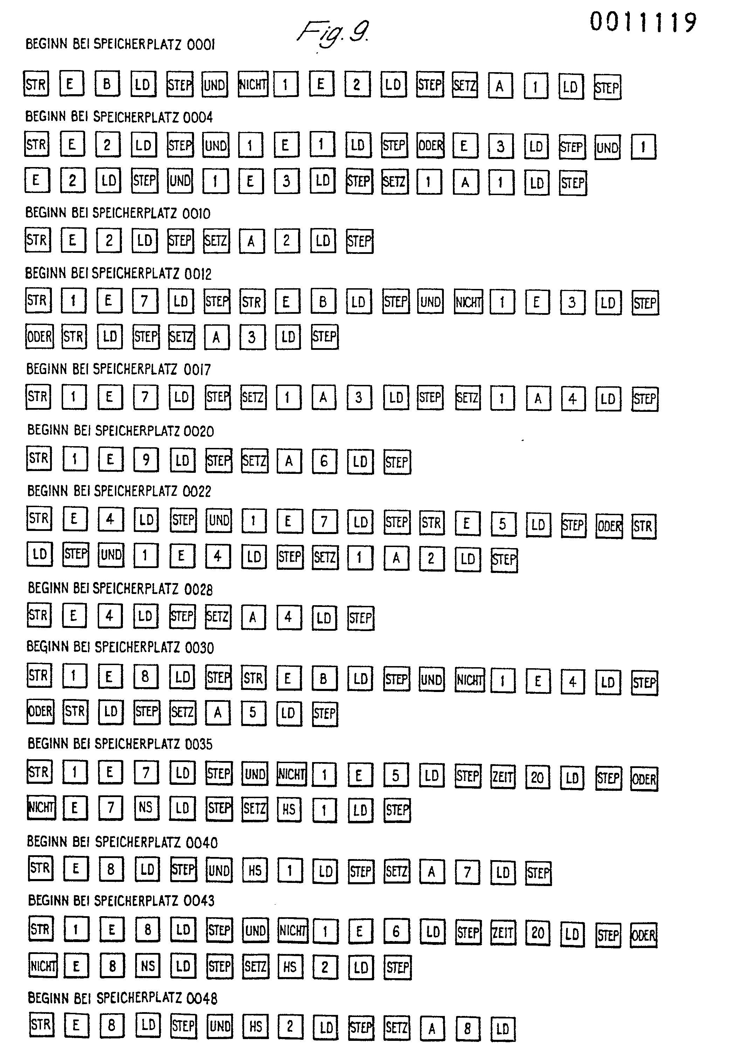

Fig. 9 zeigt ein Beispiel dafür, wie mittels einzelner Tasten
ein zu der Darstellung der Fig. 7 und 8 gehörendes Programm
eingegeben werden kann, wobei mittels der Taste "STEP" der nächste
Speicherplatz aufgerufen wird, die Taste "LD" (Laden) die Einschreibung einer Funktion möglich macht, die Taste "SETZ" (Setzen)
einen Ausgang anwählt und über die Taste "STR" (Strompfad)
der nächste Strompfad angewählt wird. Über die Taste "NS" (nicht
speichern) wird aus dem statischen Befehl einer Taste eine reine
Impulsgabe.

Gemäß der obersten Anordnung von Tasteneingaben wird also folgendes veranlaßt:
Durch Drücken der Taste STR wird der erste Strompfad (in Fig. 8
der am weitesten links liegende Strompfad für den Frostschutz)
angewählt. Mit dem Niederdrücken der Tasten E und B wird der
Blinkimpuls EB adressiert und anschließend mit der Taste "LD"
diese Funktion eingeschrieben. Durch das Drücken der Taste "STEP"
wird der nächsten Speicherplatz 0002 angerufen. Durch Drücken
der Tasten "UND" "NICHT" sowie der Tasten 1, E, 2 und "LD" wird
die Funktion "UND NICHT 1 E 2" am Speicherplatz 0002 geladen.

Durch das Niederdrücken der Tasten "SETZEN" wird ein Ausgang
angewählt, der durch das Niederdrücken der Tasten A und 1 adressiert wird. Mit dem Niederdrücken der Taste "LD" wird somit
die Funktion "SETZEN A 1" an den Speicherplatz 0003 geladen.

Entsprechend setzt sich die Programmeingabe in den nächsten
Zeilen fort.

Die einzelnen Steckkarten besitzen, wie bereits eingangs ausgeführt, Codierungen, die durch Codierschalter oder durch Steckbrücken möglich sind. Die einzelnen Auslösefunktionen für die
Drucktasten können zweckmäßigerweise in binärer Form codiert
werden, wobei die weiter oben genannten sieben unterschiedlichen
Möglichkeiten mit den Bezeichnungen 1 bis 7 versehen werden
können. Im vorliegenden Falle müßte die in Fig. 5 links dargestellte Steckkarte mit der Funktion 3 codiert werden, gemäß
der eine Taste einzeln ist, während zwei Tasten sich gegenseitig
auslösen und zwei weitere Tasten sich ebenfalls gegenseitig
auslösen. Die in Fig. 5 dargestellte zweite Steckkarte müßte
gemäß der Funktion 1 codiert werden, gemäß der keine gegenseitige
Auslösung der Tasten erfolgt, d. h., daß alle Tasten voneinander
unabhängig sind.

Mit Hilfe des Programmdruckers 66, der in Fig. 4 dargestellt
ist, läßt sich das gespeicherte Programm in Stromlaufplanform
ausdrucken, wobei der Inhalt der zum Ausdruck abgerufenen Speicherplätze ausgedruckt wird.

Im Stromlaufplan werden an den Schaltsymbolen die Adressen ausgedruckt. Um das Nachvollziehen einer Funktion zu erleichtern,
wird unter jedem Stromlaufplanabschnitt das Anwenderprogramm
in seiner Gesamtheit ausgedruckt. Dieser Ausdruckabschnitt enthält die Speicherplatznummer, die logische Funktion, die Adresse
und die Klartextbezeichnung der Adresse.

Für diesen Klartextausdruck wird die zu Beginn der Programmierung
eingeschriebene Belegungsliste verwendet. Das gemäß Fig. 9 eingegebene Programm ist in den Fig. 10, 11 und 12 vom Drucker abgedruckt. In einer Stromlaufplankette sind zehn Symbole hintereinander möglich.

Abschließend sei nochmals der Arbeitsablauf bei der Erstellung einer Anlage, z. B. Klimaanlage dargelegt, um zu zeigen, in welch einfacher Weise mit Hilfe der erfindungsgemäßen Anzeige- und Bedienungselemente ein Steuerungssystem aufgebaut und ggf. abgewandelt werden kann.

Folgende Arbeitsschritte sind notwendig:

1. Ermittlung der benötigten Anzeige- und Bedienungselementkarten und der zugehörigen Eingabe/Ausgabekarten;

2. Beschriften und Codieren der Anzeige- und Bedienungselementkarten;

3. Erstellen der Eingabe/Ausgabebelegungsliste gemäß Fig. 7 (kann handschriftlich erfolgen);

4. Erstellen des Klemmenbelegungsplanes für die Eingabe/Ausgabesteckkarten;

5. Einbau der Eingabe/Ausgabekarten im Schaltschrank und Verdrahtung nach der Klemmenbelegungsliste;

6. Erstellen des Verknüpfungskonzeptes gemäß Fig. 8 (kann handschriftlich erfolgen);

7. Bestücken des Steuerungssystems mit den Anzeige- und Bedienungselementkarten;

8. Bestückung des System mit einer RAM-Speicherkarte;

9. Einschreiben der Eingabe/Ausgabebelegungsliste im Speicher des Programmiergerätes (Fig. 9);

10. Einschreiben des Verknüpfungskonzeptes mittels Programmiergerät in den RAM-Speicher des Steuerungssystems;

11. Testen des Programms mit einem Simulator;

12. Änderung bzw. Ergänzung des Programms soweit erforderlich;

13. Laden des RAM-Speicherinhalts im EPROM-Speicher;

14. Auswechseln des RAM-Speichers des Steuerungssystems gegen diesen EPROM-Speicher;

15. Ausdruck des Gesamtprogramms (Fig. 10 bis 12); und

0011119

16. Laden des gesamten Programms auf eine Kassette einschließlich der Eingabe/Ausgabebelegungsliste zum Zwecke der
Archivierung.

ES/jn 5

·7926

·WLW-Elektrotechnik GmbH & Co. KG
4150 Krefeld 1

·P a t e n t a n s p r ü c h e :

1.  Anzeige- und Bedienungselement, das mehrere, ggf. sich
    gegenseitig auslösende Leuchtdrucktasten auf einer in ein
    Gehäuse einschiebbaren Karte aufweist, dadurch gekennzeich-
    net, daß die Funktion und ggf. gewünschte gegenseitige
    Auslösung elektrisch mit Hilfe von Schaltkreisen festgelegt wird, deren Anordnung bzw. Einstellung ohne Verdrahtungsänderung mittels auf der Steckkarte (50) angeordneter
    Codierschalter (44), Kreuzschienenverteiler, Steckbrücken
    o. dgl., oder durch die Programmierung (Software) eines
    Mikroprozessors (14) einstellbar ist.

2.  Anzeige- und Bedienungselement nach Anspruch 1, dadurch
    gekennzeichnet, daß die Steckkarte (50) mit anderen, iden-
    tisch aufgebauten Steckkarten über im Gehäuse (10) angeordnete Steckkontaktleisten (46, 48), die ihrerseits über
    vielpolige Bandkabel, Druckplatten o. dgl. miteinander
    verbunden sind, bezüglich ihrer einzelnen Steckkontakte
    (40) parallelgeschaltet ist.

3.  Anzeige- und Bedienungselement nach Anspruch 1 oder 2,
    dadurch gekennzeichnet, daß ein oder mehrere jeweils das
    Anzeige- und Bedienungselement tragende Karten (50) zusammen
    mit ggf. mit Relais und Optokopplern bestückten und als Schnittstelle zwischen Steuersystem und zu steuernden Anlagen dienenden Ein/Ausgabekarten (62) innerhalb eines
Gehäuses (10) angeordnet sind und über Datenbusleitungen
(54, 56, 58) mit weiteren, mit Karten bestückten Gehäusen
(10) und/oder mit einem Zentralgerät (60) verbunden ist,
über das mittels einer Programmiereinrichtung (64, 66)
vorhandene Mikroprozessoren programmierbar sind.

4. Anzeige- und Bedienungselement nach Anspruch 3, dadurch
gekennzeichnet, daß die das Anzeige- und Bedienungselement
tragende Karte und die ggf. mit Relais und Optokopplern
bestückte Ein/Ausgabekarte zu einer einzigen Steuerkarte
(100) vereinigt sind.

5. Anzeige- und Bedienungselement nach Anspruch 4, dadurch
gekennzeichnet, daß die Steuerkarte (100), insbesondere
an ihrer Frontkante, noch eine einen Adressierschalter
(102), Zustandsanzeigelampen für externe Eingänge und externe
Ausgänge (104, 106), Prüfschalter (103) zur Umschaltung
von durch die Elektronik gesteuerten Ausgängen auf Handsteuerung, Steckleisten (116) für durch Hardware gebildete,
insbesondere RC-Glieder darstellende Zeitglieder und/oder
ein eigenes Betriebsspannungsversorgungsteil (114) aufweist.

6. Anzeige- und Bedienungselement nach Anspruch 2, dadurch
gekennzeichnet, daß eine Karte (50) einen Mikroprozessor
(14) aufweist und mit mehreren mit Leuchtdrucktasten (42)
versehenen weiteren untereinander identischen Karten (50)
elektrisch über die Steckkontaktleisten (46, 48) verbunden,
vorzugsweise bezüglich ihrer einzelnen Steckkontakte (40)
parallelgeschaltet ist.

7. Anzeige- und Bedienungselement nach einem der Ansprüche
1 bis 5, dadurch gekennzeichnet, daß die Steckkarte (50)
für die Bildung der Funktions- und Auslöseschaltkreise,
z. B. für den Blinkbetrieb der Anzeigelampe (22) integrierte
Schaltkreise (36) und/oder für den Betrieb der Leuchtelemente (22) der Leuchtdrucktasten (42) (z. B. Glühbirnen, Leuchtdioden) einen Halbleiterlampentreiberkreis (38) aufweist.

8.  Anzeige- und Bedienungselement nach einem der Ansprüche
    1 bis 7, dadurch gekennzeichnet, daß jeder Taste (42)
    einer Steckkarte (50) ein zwei Zustände aufweisender Speicher (z. B. Flipflop) (34) zugeordnet ist, der durch einen
    beim Niederdrücken der zugehörigen Taste (42) (falls Taste
    unabhängig ist) oder durch Niederdrücken einer anderen
    Taste (bei gegenseitiger Auslösung) entstehenden Impuls
    in seinen anderen Zustand gebracht wird.

9.  Anzeige- und Bedienungselement nach Anspruch 4, dadurch
    gekennzeichnet, daß jede Karte zur Codierung der Tastenfunktion drei binäre Codierschalter, Steckbrücken o. dgl.
    aufweist, die die Funktion von bis zu acht auf der Karte
    (50) untergebrachten Leuchttasten festlegen.

10. Anzeige- und Bedienungselement nach Anspruch 8 oder 9,
    dadurch gekennzeichnet, daß die Speicher sich im Zentralgerät (60) befinden und bezüglich des Steuerungsprogramms
    einen haftenden Speicher (ROM-Speicher) oder einen nichthaftenden Speicher (RAM-Speicher) darstellen und daß ggf.
    die Steuerkarte (50) eine Notbatterie zur Versorgung von
    Speichern mit bei Stromausfall verlierbarem Inhalt aufweist.

11. Anzeige- und Bedienungselement nach einem der Ansprüche
    3 bis 10, dadurch gekennzeichnet, daß das Zentralgerät
    (60) einen 8-Bit-Mikroprozessor und einen 1-Bit-Mikroprozessor aufweist, daß weiterhin Speicherraum für alle angeschlossenen Einzeltasten (42), für einen internen festen
    Arbeitsprogrammteil und für einen frei programmierbaren
    Arbeitsprogrammteil vorhanden ist, wobei die Speicherung
    des internen festen Arbeitsprogrammteils vorzugsweise in
    PROM-Speicherkarten mit unverlierbarem Inhalt erfolgt und
    die Speicherung des frei programmierbaren Arbeitsprogrammteils vorzugsweise entweder ebenfalls in PROM-Speicherkarten

0011119

oder in batteriegepufferten RAM-Speicherkarten erfolgt.

12. Anzeige- und Bedienungselement nach Anspruch 11, dadurch
gekennzeichnet, daß RAM-Speicherkarten zum Austesten der
Anlage und zur schnellen Änderung und/oder Ergänzung des
Anwenderprogramms vorgesehen sind und vorzugsweise einen
Speicherinhalt von 4096 Worten (1 Wort = 1 logische Funktion)
besitzen, und daß die PROM-Speicherkarte zur Speicherung
ausgetesteter Programme dient und einen Speicherinhalt
von vorzugsweise 1024 Worten aufweist, der durch Ergänzungssteckeinheiten auf vorzugsweise 4096 Worte erweiterbar
ist.

13. Anzeige- und Bedienungselement nach einem der Ansprüche
1 bis 12, dadurch gekennzeichnet, daß die Busleitungen
Ringleitungen aus Koaxialkabel sind und eine Datenwortstruktur übertragen, die aus zumindest 12 Bit-Worten plus Vorzeichen-Bit besteht (Wortlänge dabei 16 Bit).

14. Anzeige- und Bedienungselement nach einem der Ansprüche
3 bis 13, dadurch gekennzeichnet, daß die Taste über ein
RC-Glied entprellt ist und daß alle Steuerungs- und Speicherfunktionen einschließlich der gegenseitigen Auslösung durch
den Mikroprozessor erfolgen.

15. Anzeige- und Bedienungselement nach Anspruch 3, dadurch
gekennzeichnet, daß die Programmiereinrichtung einen Programmdrucker (66) zum Ausdruck des gespeicherten Programms (Fig.
10, 11, 12) aufweist, insbesondere in Form von Stromlaufplansymbolen.

0011119

Fig. 1.

Fig. 2.

Fig. 3a.

Fig. 3b.

0011119

*Fig. 4.*

ZENTRALGERÄT

60

12

11

10

54 — 58

8E 8A   8E 8A   8E 8A   8E 8A

62

8E 8A   8E 8A   8E 8A   8E 8A

56 — 59

PROGRAMMIERKOFFER

64

PROGRAMMDRUCKER

66

ZU WEITEREN
STEUEREINHEITEN 10

*Fig. 5.*

| FROST-SCHUTZ |
| ZULUFT AUTO-MATIK |
| ZULUFT HAND |
| ABLUFT AUTO-MATIK |
| ABLUFT HAND |

| REGE-LUNG |
| ZULUFT LUFTM. ENTRIEG |
| ABLUFT LUFTM. ENTRIEG |

Fig. 6.

## Fig. 7.

EINGABE/AUSGABE-KARTE

| KLEMME NR. 1 | | BEZEICHNUNG | GERÄT KLEMME NR. | INDEX |
|---|---|---|---|---|
| E1 | | SCHALTUHR | | d3 |
| E2 | | FROSTSCHUTZTHERMOSTAT | a | e1 |
| E3 | | ÜBERSTROMAUSLÖSER ZULUFT | 2 | e2 |
| E4 | | ÜBERSTROMAUSLÖSER ABLUFT | g5 | e3 |
| E5 | | DRUCKSCHALTER ZULUFT | g5 | e4 |
| E6 | | DRUCKSCHALTER ABLUFT | 4 | e5 |
| E7 | | RÜCKMELDUNG ZULUFT | 6 | c1 |
| E8 | | RÜCKMELDUNG ABLUFT | 14 | c2 |
| E9 | | RÜCKMELDUNG REGELUNG | 14 | d7 |
| 10 | | | 14 | |
| A1 | ⚬⚬ | ZULUFTVENTILATOR – SCHÜTZ | PHASE | |
| 11 | | | | c1 |
| 20 | | | a | |
| A2 | ⚬⚬ | ABLUFTVENTILATOR – SCHÜTZ | PHASE | |
| 21 | | | | c2 |
| 30 | | ZU | a | |
| A3 | ⚬⚬ | KLAPPENSTELLMOTOR | 8 | |
| 31 | | AUF | PHASE | |
| 40 | | | 7 | |
| A4 | ⚬⚬ | REGELUNGSTREIGABE | PHASE | |
| 41 | | | a | d7 |

Fig. 8.

Fig. 9.

0011119

BEGINN BEI SPEICHERPLATZ 0001
STR E B LD STEP UND NICHT 1 E 2 LD STEP SETZ A 1 LD STEP

BEGINN BEI SPEICHERPLATZ 0004
STR E 2 LD STEP UND 1 E 1 LD STEP ODER E 3 LD STEP UND 1
E 2 LD STEP UND 1 E 3 LD STEP SETZ 1 A 1 LD STEP

BEGINN BEI SPEICHERPLATZ 0010
STR E 2 LD STEP SETZ A 2 LD STEP

BEGINN BEI SPEICHERPLATZ 0012
STR 1 E 7 LD STEP STR E B LD STEP UND NICHT 1 E 3 LD STEP
ODER STR LD STEP SETZ A 3 LD STEP

BEGINN BEI SPEICHERPLATZ 0017
STR 1 E 7 LD STEP SETZ 1 A 3 LD STEP SETZ 1 A 4 LD STEP

BEGINN BEI SPEICHERPLATZ 0020
STR 1 E 9 LD STEP SETZ A 6 LD STEP

BEGINN BEI SPEICHERPLATZ 0022
STR E 4 LD STEP UND 1 E 7 LD STEP STR E 5 LD STEP ODER STR
LD STEP UND 1 E 4 LD STEP SETZ 1 A 2 LD STEP

BEGINN BEI SPEICHERPLATZ 0028
STR E 4 LD STEP SETZ A 4 LD STEP

BEGINN BEI SPEICHERPLATZ 0030
STR 1 E 8 LD STEP STR E B LD STEP UND NICHT 1 E 4 LD STEP
ODER STR LD STEP SETZ A 5 LD STEP

BEGINN BEI SPEICHERPLATZ 0035
STR 1 E 7 LD STEP UND NICHT 1 E 5 LD STEP ZEIT 20 LD STEP ODER
NICHT E 7 NS LD STEP SETZ HS 1 LD STEP

BEGINN BEI SPEICHERPLATZ 0040
STR E 8 LD STEP UND HS 1 LD STEP SETZ A 7 LD STEP

BEGINN BEI SPEICHERPLATZ 0043
STR 1 E 8 LD STEP UND NICHT 1 E 6 LD STEP ZEIT 20 LD STEP ODER
NICHT E 8 NS LD STEP SETZ HS 2 LD STEP

BEGINN BEI SPEICHERPLATZ 0048
STR E 8 LD STEP UND HS 2 LD STEP SETZ A 8 LD

## Fig.10.

DR 0001-0021

| 0001 STR | EB BLINKIMPULS |
|---|---|
| 0002 UND NICHT | 1E2 FROSTSCHUTZ |
| 0003 SETZ | A1 FROSTSCHUTZ |
| 0004 STR | E2 ZUL. AUTOM. |
| 0005 UND | 1E1 SCHALTUHR |
| 0006 ODER | E3 ZUL. HAND |
| 0007 UND | 1E2 FROSTSCHUTZ |
| 0008 UND | 1E3 ÜBERSTROM ZUL. |
| 0009 SETZ | 1A1 ZUL.-VENT |
| 0010 STR | E2 ZUL. AUTOM. |
| 0011 SETZ | A2 ZUL. AUTOM. |
| 0012 STR | 1E7 RÜCKM. ZUL. |
| 0013 STR | EB BLINKIMPULS |
| 0014 UND NICHT | 1E3 ÜBERSTROM ZUL. |
| 0015 ODER STR | |
| 0016 SETZ | A3 ZUL. HAND |
| 0017 STR | 1E7 RÜCKM. ZUL. |
| 0018 SETZ | 1A3 KLAPPE |
| 0019 SETZ | 1A4 REGELUNG |
| 0020 STR | 1E9 RÜCKM. REG. |
| 0021 SETZ | A6 REGELUNG |

0011119

## Fig. 11.

DR 0022-0034

| | |
|---|---|
| 0022 STR | E4 ABL.AUTOM. |
| 0023 UND | 1E7 RÜCKM. ZUL. |
| 0024 STR | E5 ABL. HAND |
| 0025 ODER STR | |
| 0026 UND | 1E4 ÜBERSTROM ABL. |
| 0027 SETZ | 1A2 ABL.- VENT. |
| 0028 STR | E4 ABL. AUTOM. |
| 0029 SETZ | A4 ABL. AUTOM. |
| 0030 STR | 1E8 RÜCKM. ABL. |
| 0031 STR | EB BLINKIMPULS |
| 0032 UND NICHT | 1E4 ÜBERSTROM ABL. |
| 0033 ODER STR | |
| 0034 SETZ | A5 ABL. HAND |

0011119

## Fig. 12

DR 0035-0050

| 0035 STR | 1E7 RÜCKM. ZUL. |
|---|---|
| 0036 UND NICHT | 1E5 DRUCK ZUL. |
| 0037 ZEIT 20" | |
| 0038 ODER NICHT NS | E7 LUFTM. ZUL. ENTR. |
| 0039 SETZ | HS1 |
| 0040 STR | EB BLINKIMPULS |
| 0041 UND | HSI |
| 0042 SETZ | A7 LUFTM. ZUL. |
| 0043 STR | 1E8 RÜCKM. ABL. |
| 0044 UND NICHT | IE6 DRUCK ABL. |
| 0045 ZEIT 20" | |
| 0046 ODER NICHT NS | E8 LUFTM. ABL. ENTR. |
| 0047 SETZ | HS2 |
| 0048 STR | EB BLINKIMPULS |
| 0049 UND | HS2 |
| 0050 SETZ | A8 LUFTM. ABL. |

MIA2

0011119

Fig.13.

Fig.14.

**Europäisches Patentamt**

**EUROPÄISCHER RECHERCHENBERICHT**

Nummer der Anmeldung
EP 79 10 3761

| | EINSCHLÄGIGE DOKUMENTE | | KLASSIFIKATION DER ANMELDUNG (Int.Cl ?) |
|---|---|---|---|
| Kategorie | Kennzeichnung des Dokuments mit Angabe, soweit erforderlich, der maßgeblichen Teile | betrifft Anspruch | G 05 B 19/10 |
| | FR - A - 2 341 984 (LOEWE-OPTA)<br>* Seite 3, Zeile 25 bis Seite 6, Zeile 4; Figuren 1,2 *<br><br>-- | 1,8 | |
| | FR - A - 2 297 273 (DOUBLE FELL)<br>* Seite 4, Zeilen 9-33; Seite 5, Zeilen 10-27; Seite 12, Zeilen 28-33; Figur 1 *<br><br>-- | 1,5,8, 10 | |
| | FR - A - 2 368 749 (SIEMENS)<br>* Seite 1, Zeile 19 - Seite 2, Zeile 5; Seite 6, Zeilen 13-16 *<br><br>-- | 10-12 | RECHERCHIERTE SACHGEBIETE (Int Cl)<br><br>G 05 B 19/10<br>H 03 K 3/02 |
| | FR - A - 2 197 194 (SALLIN P.)<br>* Seite 1, Zeile 24 - Seite 2, Zeile 1; Seite 2, Zeilen 27-31; Seite 2, Zeile 36 - Seite 3, Zeile 6; Figuren 1,2 *<br><br>-- | 3,4 | |
| | DE - A - 2 162 768 (METRAWATT)<br>* Seite 4, Zeilen 14-31; Figuren *<br><br>---- | 2,3,5 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt

| Recherchenort Den Haag | Abschlußdatum der Recherche 25-02-1980 | Prüfer RUGGIU |
|---|---|---|

EPA form 1503.1 06.78